# EUROPEAN PATENT APPLICATION

(11) **EP 4 835 494 A1**
(43) Date of publication of application: **04.11.2026**
(21) Application number: 26175230.7
(22) Date of filing: 28.04.2026
(51) Int. Cl.: G01R 1/20, G01R 19/00, G01R 1/04, H02B 1/00

(54) **ELECTRICAL DISTRIBUTION SYSTEM**

(30) Priority: 29.04.2025 GB 202506446
(71) Applicant: Rayleigh Instruments Limited, South Woodham Ferrers, Chelmsford, Essex CM3 5WA (GB)
(72) Inventor: Brookes, Matthew, Chelmsford, CM3 5WA (GB)
(74) Representative: D Young & Co LLP

(57) **Abstract**

An electrical distribution system comprises distribution circuitry to distribute an electrical supply to a plurality of subsidiary circuits, and a plurality of current carriers, each current carrier providing an electrical connection between the distribution circuitry and a corresponding subsidiary circuit. At least two of the plurality of current carriers each comprise an integrated shunt resistor configured such that current passing through the electrical connection between the distribution circuitry and the corresponding subsidiary circuit passes through the integrated shunt resistor, and a pair of output connections configured to allow electrical measurements to be taken from across the integrated shunt resistor.

## Description

### Technical Field

The proposed technique relates to electrical distribution systems.

### Technical Background

Electrical distribution systems, such as consumer units, are used to distribute an electrical supply from a mains source to a plurality of subsidiary circuits. Current monitoring of individual subsidiary circuits within such distribution boards may be performed using current transformers or other series-connected monitoring devices installed on each outgoing circuit.

### SUMMARY

At least some examples provide an electrical distribution system comprising: distribution circuitry configured to distribute an electrical supply to a plurality of subsidiary circuits, wherein the distribution circuitry comprises a comb linking bar; a plurality of current carriers, each current carrier comprising a respective protrusion of the comb linking bar, and configured to provide an electrical connection between the distribution circuitry and a corresponding subsidiary circuit, wherein at least two of the plurality of current carriers each comprise: an integrated shunt resistor configured such that current passing through the electrical connection between the distribution circuitry and the corresponding subsidiary circuit passes through the integrated shunt resistor; and a pair of output connections configured to allow electrical measurements to be taken from across the integrated shunt resistor.

Further aspects, features and advantages of the proposed approach will be apparent from the following description of examples, which is to be read in conjunction with the accompanying drawings.

### BRIEF DESCRIPTION OF THE DRAWINGS

The proposed approach will be described further, by way of example only, with reference to the accompanying drawings, in which:
Figure 1 illustrates a conventional approach for monitoring subsidiary circuits in a single-phase distribution system;
Figure 2 illustrates an example of a single-phase distribution system comprising integrated shunt resistors;
Figure 3 illustrates a schematic view of a three-phase pan assembly;
Figure 4 illustrates an example of a three-phase pan assembly comprising integrated shunt resistors;
Figure 5 illustrates a pan assembly with connected circuit protection devices;
Figure 6 illustrates a pan assembly comprising integrated shunt resistors;
Figure 7 illustrates a pan assembly;
Figure 8 illustrates an electrical distribution system comprising integrated shunt resistors;
Figures 9A and 9B illustrate three-phase and single-phase pan assemblies comprising integrated shunt resistors;
Figure 10A illustrates an example of current carrier comprising an integrated shunt resistor and a pair of output connections;
Figure 10B illustrates an example of a comb busbar suitable for a single-phase supply comprising integrated shunt resistors and output connections;
Figure 10C illustrates an example of comb busbars suitable for a three-phase supply comprising integrated shunt resistors and output connections;
Figure 11 illustrates an example of a distribution system comprising energy metering modules;
Figure 12 illustrates an example of a pan assembly;
Figure 13 illustrates a comb busbar assembly comprising current transformers for monitoring subsidiary circuits;
Figure 14 illustrates a distribution board;
Figure 15 illustrates an example of a copper busbar comprising an integrated shunt resistor;
Figure 16A and Figure 16B illustrate pins for connecting to a printed circuit board for taking electrical measurements.

### DESCRIPTION OF EXAMPLES

Before discussing the embodiments with reference to the accompanying drawings, the following description of embodiments and associated advantages is provided.

Electrical distribution systems, such as consumer units or distribution boards, may be used to provide a centralised point for distributing an electrical supply to multiple subsidiary circuits within residential, commercial, and industrial installations. These distribution systems receive an incoming electrical supply and distribute the supply to individual circuit branches, each of which may serve a particular load or group of loads (e.g. lighting circuits, socket circuits, dedicated equipment supplies, etc). Monitoring the energy consumed by individual subsidiary circuits may be done by measuring the current drawn by each subsidiary circuit. One approach to current monitoring in distribution boards involves installing a current transformer or other monitoring device on each outgoing subsidiary circuit, with each current transformer positioned around the conductor carrying current to the respective subsidiary circuit, and producing an output signal proportional to the current flowing through the conductor. This approach presents several limitations due to the current transformers occupying space within the distribution board enclosure. Due to the physical size of current transformers, installations requiring current monitoring for multiple subsidiary circuits may necessitate a dedicated distribution board designed with additional space to accommodate the current transformers. In many installations, standard distribution boards lack sufficient space for current transformers (particularly for larger systems with a large number of subsidiary circuits), thereby making current monitoring impractical without constructing a purpose-built enclosure.

The installation of current transformers also introduces complexity for the installer, particularly when also installing circuit protection devices such as miniature circuit breakers, residual circuit breakers with over-current protection, and arc fault detection devices. For example, each current transformer may require manual wiring to connect the transformer output to a remote metering device. The installer selects and positions each current transformer during installation, because the specific circuit protection devices employed may vary depending on the connected subsidiary circuit. The physical size of different circuit protection devices may affect the positioning of current transformers and requires the installer to adapt the installation accordingly. For example, arc fault detection devices and residual current circuit breakers with overcurrent protection may be larger than miniature circuit breakers, and so the positioning of current transformers will vary for subsidiary circuits with different circuit protection devices.

According to the proposed approach, an electrical distribution system comprises distribution circuitry configured to distribute an electrical supply to a plurality of subsidiary circuits. The distribution circuitry receives an incoming electrical supply, e.g. from the mains electricity supply, and comprises current carries to provide electrical connections to multiple subsidiary circuits representing individual electrical loads or groups of loads that receive power from the distribution circuitry. The current carriers may serve as conductive pathways through which electrical current flows from the distribution circuitry to the subsidiary circuits such that when a subsidiary circuit draws power, the electrical current passes through the corresponding current carrier that connects the subsidiary circuit to the distribution circuitry. It will be appreciated that the particular form of a current carrier may vary depending on the particular implementation, and may be constructed from any conductive material sized to connect the distribution circuitry to the subsidiary circuit. At least two of the plurality of current carriers each comprise an integrated shunt resistor configured such that current passing through the electrical connection between the distribution circuitry and the corresponding subsidiary circuit passes through the integrated shunt resistor. For example, the integrated shunt resistor may be positioned in series between two sections of the current carrier, so that all current flowing to the corresponding subsidiary circuit passes through the integrated shunt resistor. A shunt resistor may be a low-value resistor (so as to not cause an excessive voltage drop) with a precisely known resistance. Each of the at least two current carriers further comprises a pair of output connections configured to allow electrical measurements to be taken from across the integrated shunt resistor. The pair of output connections provide access points on either side of the integrated shunt resistor, enabling measurement of the electrical flow through the integrated shunt resistor and, by extension, the current carrier to the corresponding subsidiary circuit.

This arrangement addresses the problem of space constraints associated with conventional current monitoring approaches as described above. By integrating the shunt resistors into the current carriers, the electrical distribution system enables current measurement without requiring additional space for external measurement components such as the current transformers described above. The arrangement also addresses the problem of installation complexity because the integrated shunt resistors are incorporated into the current carriers within the distribution circuitry, and therefore the measurement capability is built into the distribution infrastructure. This reduces the amount of manual wiring that an installer performs during installation, as the measurement points are already established within the current carriers of the distribution circuitry rather than requiring separate installation of current transformers for each subsidiary circuit.

In some examples, the distribution circuitry is arranged in a pan assembly. A pan assembly provides a structured arrangement for distributing an electrical supply to multiple subsidiary circuits through an organized configuration of busbars and connection points. Pan assemblies may be arranged as a lattice of copper bars that can provide a three-phase or single-phase electrical distribution. The pan assembly is typically enclosed within a plastic moulded housing that protects the internal conductors while providing access points for connecting to the subsidiary circuits. In such examples, the pan assembly facilitates the integration of shunt resistors and associated measurement electronics into the copper bars or wires that embody the current carriers connected to the subsidiary circuits within a compact form factor.

In some alternative examples, the distribution circuitry is arranged as a comb busbar or linking bar which has a number of protrusions resembling the shape of a comb. A comb busbar may be constructed from a conductive material, such as copper. In such examples, each current carrier comprises a respective protrusion of the comb busbar, such that the subsidiary circuits may be connected to those protrusions. Some examples of the comb busbar configuration are suited for single-phase distribution applications where a common live connection is distributed to multiple circuit protection devices. The protrusions extend from a main conductor bar and provide individual connection points for each subsidiary circuit. Other examples of the comb busbar may be constructed out of multiple conductor bars to distribute three-phase distribution, so that a group of three protrusions (i.e. each from three conductor bars) may provide a connection point for a subsidiary circuit.

In some examples, the electrical distribution system comprises an electrical distribution board in various implementations. The electrical distribution board provides a housing and mounting arrangement for the distribution circuitry, any circuit protection devices, and associated wiring. The electrical distribution board may comprise a consumer unit which are commonly installed in residential and light commercial premises to distribute electrical power to individual circuits throughout a building.

In some examples, the pair of output connections is configured to allow electrical measurements to be taken from a point on the current carrier that is integrated inside the electrical distribution board. This integration of the measurement point within the distribution board eliminates the requirement for external current transformers or monitoring devices that would otherwise occupy additional space outside the distribution board enclosure. The measurement capability is thus incorporated into the existing distribution infrastructure.

Each of the subsidiary circuits corresponds to at least one current carrier comprising the integrated shunt resistor and the pair of output connections in some implementations. This configuration enables comprehensive monitoring of all subsidiary circuits connected to the distribution board. In other implementations, at least one of the plurality of current carriers is configured to provide an electrical connection between the distribution circuitry and a corresponding subsidiary circuit without passing current through an integrated shunt resistor, allowing for mixed configurations where only selected circuits are provided with monitoring capability.

In some examples, current measurement circuitry is provided to take the electrical measurements from the pair of output connections and to determine a magnitude of current that is drawn by the corresponding subsidiary circuit. Depending on the nature of the electrical supply (e.g. three-phase or single-phase), the magnitudes of current in groups of current carriers may be added together to determine the total current drawn by a corresponding subsidiary circuit. Based on the current being drawn by each subsidiary circuit, it is possible to measure the energy usage of each subsidiary circuit over time.

In some examples, the current measurement circuitry is permanently connected to the pair of output connections in some implementations. For example, the connections may be constructed as part of the conducting material of the current carrier itself. A permanent connection provides a fixed monitoring arrangement that is established during manufacturing of the current carriers. In alternative implementations, the current measurement circuitry is removably connected to the pair of output connections. For example, a wire may be soft soldered to the current carrier, or a connector or screw terminal may be built into the current carrier and configured to receive a wire connection. A removable connection allows the metering measurement module to be retrofitted after installation of the distribution board, or to be replaced or upgraded without modification to the underlying distribution circuitry.

In some examples, each current carrier is configured to provide an electrical connection between the distribution circuitry and a circuit protection device for the corresponding subsidiary circuit. Examples of circuit protection devices include circuit breakers or fuses, miniature circuit breakers (MCBs), residual current circuit breakers with overcurrent protection (RCBOs), and arc fault detection devices (AFDDs). In such examples, the pair of output connections may be provided at a portion of the current carrier that is on a distribution side of the circuit protection device. The distribution side of the circuit protection device is a side connected to the distribution circuitry, and the distribution side is opposite to a subsidiary circuit side at which the circuit protection device is connected to the corresponding subsidiary circuit. This arrangement further reduces the size required for the electrical distribution system and allows the measurement capability to be independent of the specific type or size of circuit protection device installed for each subsidiary circuit. In particular, by locating the measurement points on the distribution side rather than on the subsidiary circuit side, the current measurement arrangement accommodates different circuit protection device configurations without requiring modification to the measurement system. Circuit protection devices may then be connected to the current carriers in a conventional manner, thereby avoiding additional installation complexity.

In some examples, the electrical measurements comprise a voltage drop across the integrated shunt resistor. For example, the pair of output connections may be connected to terminals of a voltmeter which measures the electrical potential difference on either side of the integrated shunt resistor. The magnitude of the current through the current carrier may then be calculated by dividing the voltage drop by the known resistance of the integrated shunt resistor.

In some examples, the at least two current carriers provide electrical connections between the distribution circuitry and at least two different subsidiary circuits. This arrangement enables simultaneous monitoring of multiple circuits within the distribution system.

In three-phase implementations, the electrical supply comprises a three-phase supply, and three of the plurality of current carriers are configured to provide three out-of-phase electrical connections between the distribution circuitry and a given one of the subsidiary circuits. Three-phase power is typically used to provide constant power for large industrial equipment, for example. In such examples, each of the three of the plurality of current carriers comprises the integrated shunt resistor and the pair of output connections, enabling complete monitoring of three-phase loads. When the magnitudes of the current being drawn through each current carrier are determined, these can be added together to determine the total current draw of the three-phase subsidiary circuit.

In single-phase implementations, the electrical supply comprises a single-phase supply, and each of the plurality of current carriers is configured to provide the electrical connection to different subsidiary circuits. The single-phase configuration distributes a common live connection to different subsidiary circuits through respective current carriers. Single-phase power is typically used in residential or commercial installations for lighting and small nonindustrial equipment.

Various examples of the electrical distribution system for distributing three-phase and single-phase power may be provided as a pan assembly or as a comb busbar. In some examples, a single electrical distribution system may distribute three-phase power to some subsidiary circuits, and single-phase power to other subsidiary circuits. In any such combination of these arrangements, the proposed approach of the integrated shunt resistor as part of the current carrier may function in the same way.

In some examples, each of the plurality of current carriers comprises a busbar. Busbars may be made from copper conductors that carry electrical current within a pan assembly or distribution board, for example.

The integrated shunt resistor is made of resistive material, which in some examples may be manganin. Manganin is a copper-manganese-nickel alloy that exhibits a low temperature coefficient of resistance, providing stable resistance values across varying operating temperatures. Such properties are useful for providing a known resistance which can be used to reliably and accurately determine the current draw through the current carrier. Other resistive materials may also be used in alternative implementations.

In some examples, the electrical distribution system is provided with current measurement circuitry configured to take the electrical measurements from the pair of output connections and to determine a magnitude of current that is drawn by the corresponding subsidiary circuit. The calculation of power and energy may be performed by, for example a processor, and the energy usage may be displayed on a metering module connected to the current measurement circuitry.

In pan assembly implementations, the at least one metering module may be positioned in a housing configured to cover the pan assembly. As above, since the integrated shunt resistor and measurement may be contained within existing housings, a metering module may be added, for example, in the shell of the housing, so that the energy usage may be observed and monitored without needing to open the housing or using specialised measuring equipment. The metering module may be added during manufacturing of the pan assembly or retrofitted after installation of the distribution board.

From the above examples, the proposed technique provides a concept for current/energy monitoring in MCB distribution assemblies (consumer units, distribution boards etc). This can be applied to single and three-phase distribution applications.

Further examples will now be described with reference to the accompanying drawings.

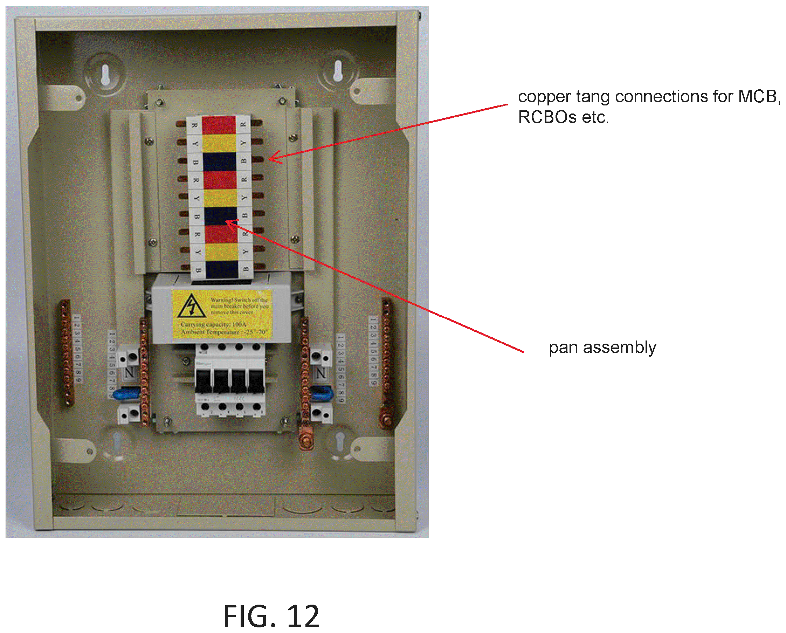

Electrical distribution boards allowing the connection of circuit protection devices such as MCBs (miniature circuit breakers), RCBOs (residual circuit breaker with over-current protection), AFDD (arc fault detection devices) etc for individual power circuits are typically arranged as shown in Figure 12. The circuit protective devices are connected to a pan assembly that distributes the supplied mains supply to small L1, L2, L3 copper tangs that the devices are connected to (NOTE: there are also single-phase pan assemblies that function the same, but all connections are instead common to the one phase).

The pan assembly includes distribution circuitry configured to provide electrical connections to circuit protection devices. The pan assembly features copper tang connections arranged in a vertical configuration at the upper portion of the assembly. The copper tang connections may be labelled and/or colour-coded corresponding to the three phases L1, L2, and L3 of a three-phase electrical supply system. The copper tang connections are configured to receive circuit protection devices such as miniature circuit breakers and residual current circuit breakers with overcurrent protection. Multiple rows of connection points are positioned on either side of a central busbar arrangement, providing positions for mounting various circuit protection devices.

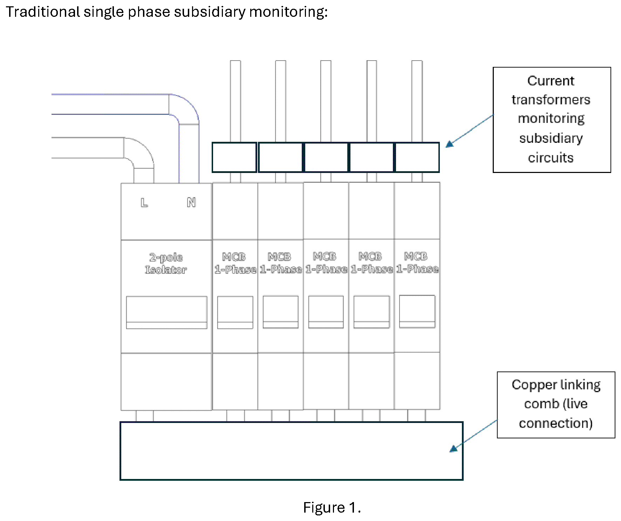

Currently, to facilitate current monitoring in such distribution boards, the installer or manufacturer is required to fit a current transformer per outgoing subsidiary circuit. This involves the placement of a current transformer, wiring, and provision of the required space - in most cases, due to the size of a current transformer, this requires a dedicated board to be designed that provides the required space (see Figure 1). For each current transformer installed, the installer needs to manually run wires back to a remote metering device. There are current transformers that provide this connection via wireless means. However, even with wireless solutions, this does still not address the space concerns mentioned above.

Whether wired, or wireless current transformers are used, they still must be selected and installed by the final installer during installation since the protective devices employed vary depending on the connected subsidiary circuit. The position of the current transformer may also vary due to size differences between protective devices (AFDD and RCBO devices tend to be much larger than, say, MCBs) - again, meaning the installer must be the person that installs them.

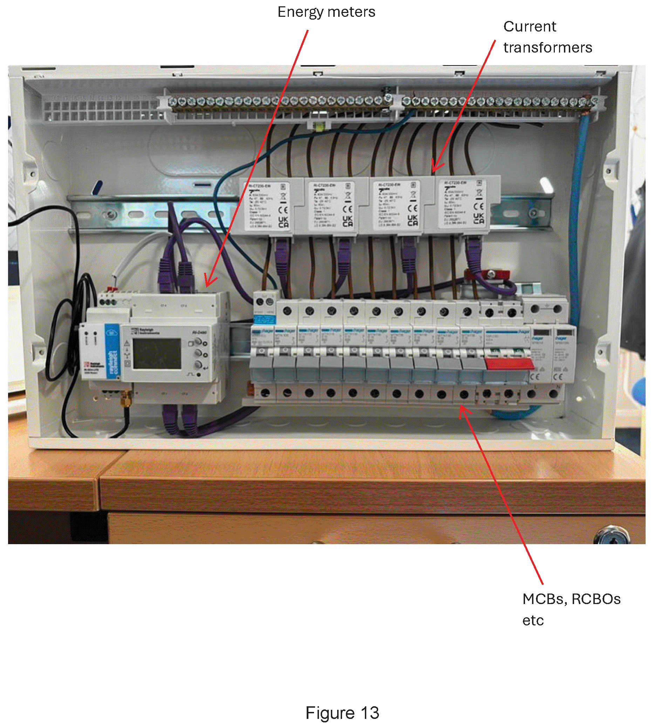

Hence, if the consumer wishes to monitor the energy consumed by each individual circuit, it is necessary to install a current transformer or other series-connected monitoring device to each outlet to measure the current. A voltage reference connection is also necessary to facilitate power and energy calculation and monitoring. An example of such an approach when implemented in a comb busbar assembly is shown in Figure 13. Systems like this require a lot of space within the distribution board and are not possible, or impractical, in most cases unless a dedicated board is constructed.

As shown in Figure 13, current transformers are installed to measure the current flowing through each circuit and positioned on the outgoing circuit conductors. The installation of current transformers on each outgoing subsidiary circuit necessitates additional space within the distribution board enclosure and requires the installer to manually run wires from each current transformer back to the energy meters or remote metering equipment. This wiring arrangement increases installation complexity and the time required for the installer to complete the monitoring system. It will be appreciated from Figure 13 that the installation of such systems can become exponentially more complex in terms of wiring and simply fitting the devices in the housing for larger distribution systems.

The method of current measurement described here alleviates the issues described above by moving the location of measurement into the point of distribution; in single phase applications this can be the copper that distributes the live connection to all the connected protective devices; in three phase applications, this can be the lattice of copper bars that provide three phase distribution to the same - known in the industry as a Pan Assembly - and typically enclosed within a plastic moulded housing.

Hence, an electrical distribution system comprises: distribution circuitry configured to distribute an electrical supply to a plurality of subsidiary circuits; a plurality of current carriers, each current carrier configured to provide an electrical connection between the distribution circuitry and a corresponding subsidiary circuit, wherein at least two of the plurality of current carriers each comprise: an integrated shunt resistor configured such that current passing through the electrical connection between the distribution circuitry and the corresponding subsidiary circuit passes through the integrated shunt resistor; and a pair of output connections configured to allow electrical measurements to be taken from across the integrated shunt resistor. In some examples, the current carriers could be considered to be comprised by the distribution circuitry.

The proposed technique described above means that no extra space is required as the measurements will be taken on the distribution side of the protective devices.

As a comparative single-phase example, Figure 1 illustrates a traditional single-phase subsidiary monitoring arrangement for an electrical distribution system. At the left side of the distribution board, a two-pole isolator is positioned to serve as the main isolation device for the incoming supply. The two-pole isolator connects to the live and neutral conductors, providing a means to disconnect the entire distribution board from the electrical supply when required for maintenance or safety purposes. Adjacent to the two-pole isolator, a series of MBCs are arranged in sequence along the distribution board. The MBCs are connected to the distribution arrangement in a linear configuration, with each miniature circuit breaker serving as a single-phase protective device for its respective outgoing circuit.

In this example, a comb busbar is positioned at the lower portion of the distribution board and provides the live connection to each of the miniature circuit breakers. This linking bar may be made of copper and comprises a number of protrusions to distribute the incoming electrical supply across all connected MBCs, establishing a common live connection point from which each subsidiary circuit branches. The comb busbar extends horizontally across the input terminals of the MBCs, providing a continuous electrical path from the two-pole isolator to each protective device. In this comparative example, current transformers are installed above the MBCs to monitor the subsidiary circuits. The current transformers are positioned on the outgoing circuit connections to measure the current flowing through each outgoing circuit connection to enable energy monitoring of individual loads.

This conventional arrangement demonstrates that current transformers are installed on each outgoing circuit to enable energy monitoring. The installation of current transformers in this manner requires additional space within the distribution board to accommodate the physical dimensions of each current transformer. Furthermore, separate wiring connections are required from each current transformer to remote monitoring equipment, necessitating manual routing of wires by the installer during installation. The space requirements and wiring complexity of this conventional approach present practical limitations, particularly in distribution boards where available space is constrained. It will also be appreciated that although a row of similar MCBs is shown in Figure 1, some installations may have some MCBs, some RCBOs, some AFDDs or other devices which may each be of a different size. Accordingly, the current transformers may need to be uniquely positioned and installed for monitoring different subsidiary circuits.

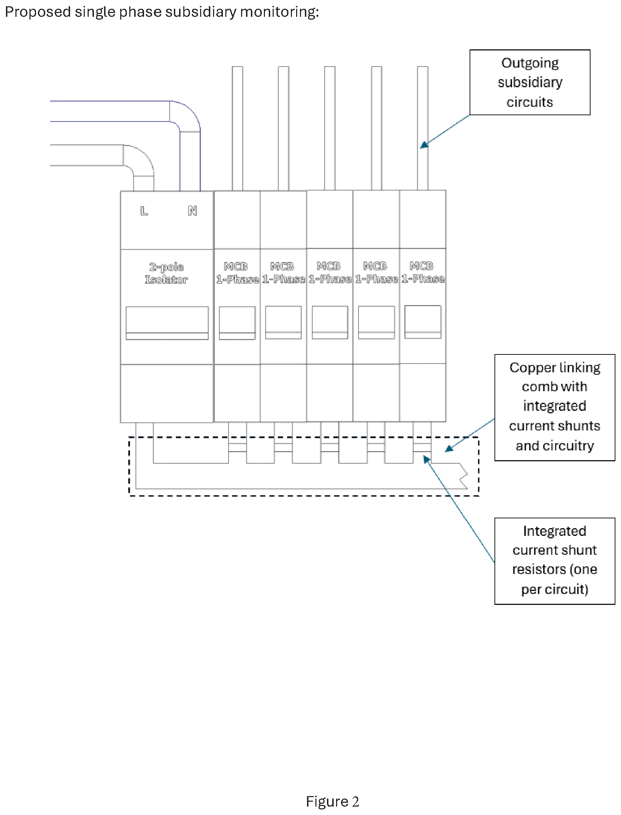

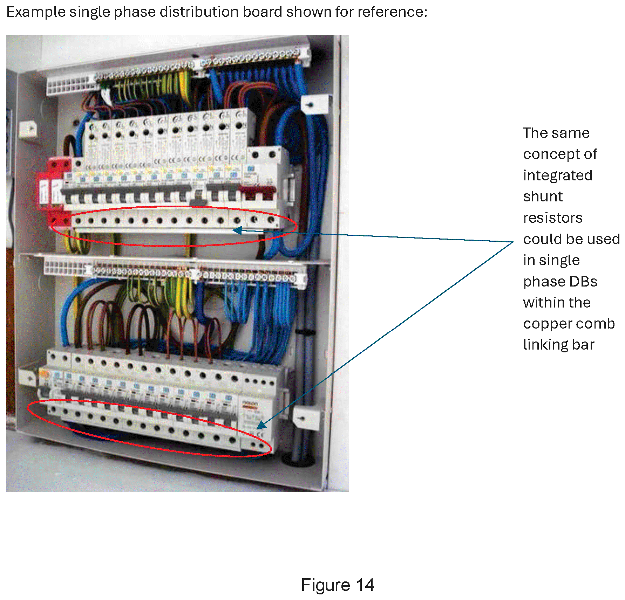

Figure 2 illustrates an example single phase subsidiary monitoring configuration for an electrical distribution system incorporating the proposed approach. The distribution arrangement includes an incoming electrical supply that enters through a two-pole isolator, which provides live and neutral connections to a series of miniature circuit breakers arranged in a row, in a similar way to Figure 1. In this example, the current carriers which comprise the integrated shunt resistances are the protrusions on the copper linking comb busbar which extend from the distribution comb busbar to each circuit protection device corresponding to respective subsidiary circuits. Figure 14 shows, for reference, a typical single phase distribution board, illustrating how the concept of integrated shunt resistors could be used within the copper comb busbar at which current is distributed to each subsidiary circuit.

The integrated shunt resistors are positioned within the comb busbar assembly on the distribution side of the circuit protection devices. This placement enables current measurements to be taken at the point where electrical current is distributed to each subsidiary circuit, rather than requiring separate current transformers or monitoring devices on the outgoing circuit side. A shunt resistor may be made of any resistive material, such as manganin, to provide a small but precisely known resistance which results in a voltage drop. The configuration enables voltage drop measurements to be taken across each integrated shunt resistor, from which the current drawn by each corresponding subsidiary circuit can be calculated. This arrangement provides current monitoring capability while maintaining a compact form factor within the distribution board, because the measurement components are integrated into the existing distribution infrastructure rather than requiring additional space for external monitoring equipment. Accordingly, installation of the MCBs shown in Figure 2 do not cause any further complexity in terms of space or wiring for providing current measurement capabilities.

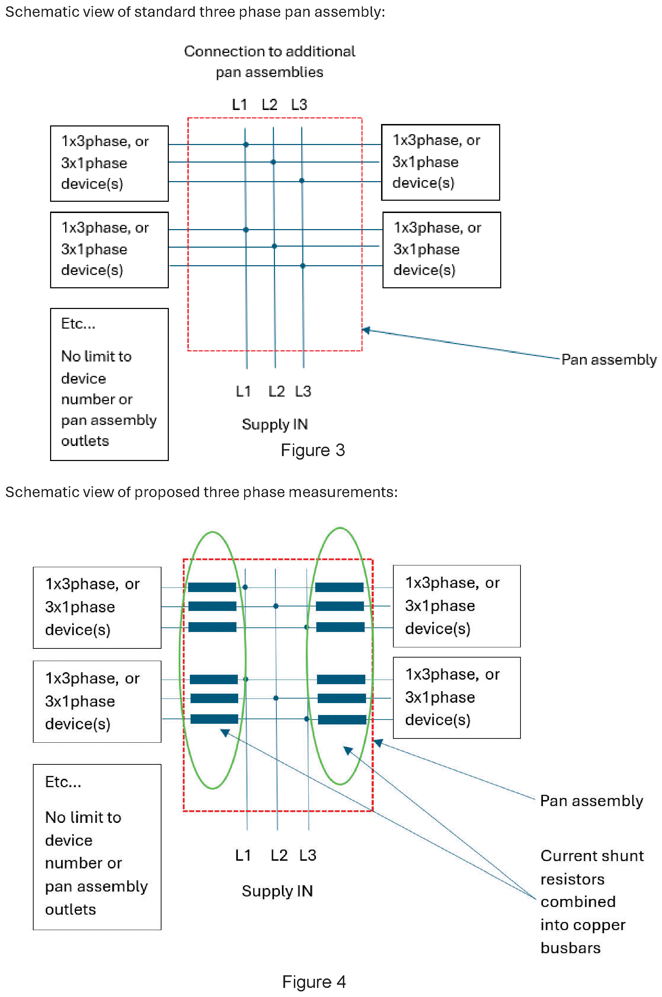

Figure 3 illustrates a schematic view of a standard three-phase pan assembly for an electrical distribution system. The pan assembly receives a three-phase electrical supply through three conductors corresponding to L1, L2, and L3, which are collectively the supply input. Three-phase conductors each carry alternating current which are 120° out-of-phase from each other to supply a consistent power supply, e.g. for large motors or industrial equipment. The distribution circuitry within the pan assembly includes connection points arranged in rows along each of the three-phase conductors which then distributes the supply input out of the pan assembly to an outlet location to which subsidiary circuits may be connected.

The pan assembly configuration is scalable, with no inherent limit to the number of devices or pan assembly outlets that can be provided. This scalability allows the distribution system to be expanded according to installation requirements. For example, the three conductors corresponding to L1, L2, and L3 may extend upward to allow additional pan assemblies to be connected, enabling expansion of the distribution network to accommodate additional subsidiary circuits.

Figure 4 shows the proposed approach when applied to a three-phase implementation, where shunt resistors are integrated into the current carriers carrying the three-phase supply to each respective subsidiary circuit. This rough schematic shows proposed integration of current measurement shunts into the copper busbars within a pan assembly. The proposed shunt resistors can be made of manganin (although other resistive materials may also be used). The voltage drop(s) across the resistor(s) can be measured and the current being drawn by the connected circuit(s) calculated. The proposed addition of these shunt resistors into the pan assembly will allow for a metering module to be combined into the pan assembly - this metering measurement module could be added during the manufacturing of the pan assembly or possibly retrofitted after installation of the distribution board.

According to this proposed approach, current monitoring capabilities may be provided for the pan-assembly and, since the shunt resistors may be integrated into the copper busbars, the additional space required inside the enclosure for the distribution is negligible. Circuit protection devices may therefore be added into the ends of the busbars in a similar way to previous conventional approaches, which also allows for easier installation.

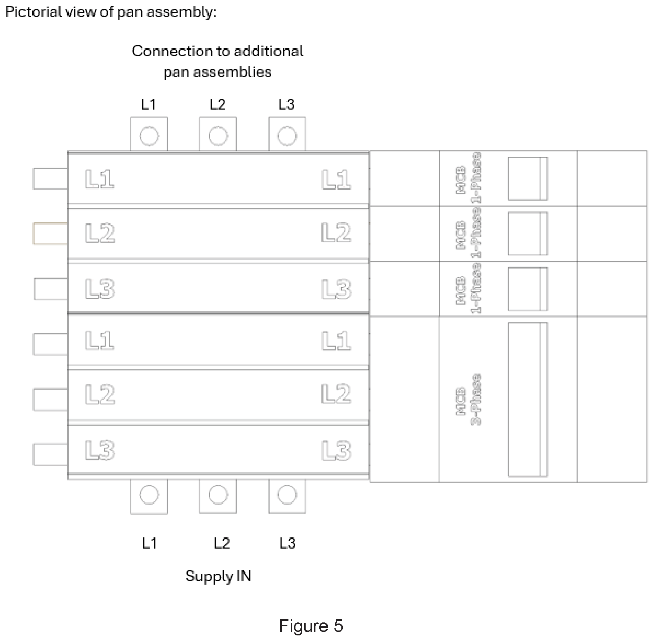

Figure 5 illustrates a view of a pan assembly for a three-phase electrical distribution system. The pan assembly includes connection points at the top and bottom of the L1, L2, and L3 busbars corresponding to the three-phase input supply. These may be connected directly to the input supply or to further pan assemblies to enable expansion of the distribution system.

The pan assembly contains two groups of three current carriers on each side. The current carriers are connected to the L1, L2, and L3 busbars to transfer the three-phase supply to subsidiary circuits. In the group of three shown towards the bottom of the figure, all three current carriers are connected to one circuit protection device in the form of a three-phase MCB. This three-phase MCB may then be connected to a subsidiary circuit. In the group of three shown towards the top of the figure, each current carrier is connected to separate single-phase MCBs.

According to the proposed approach, the integrated shunt resistors are applied to three phase distribution boards utilizing a pan assembly of the type shown in Figure 5. The current carriers within the pan assembly are configured to include integrated shunt resistors, for example, between the connection points with the input supply busbars and the output connections to the MCBs. This therefore enables current measurement for each subsidiary circuit connected to the distribution system.

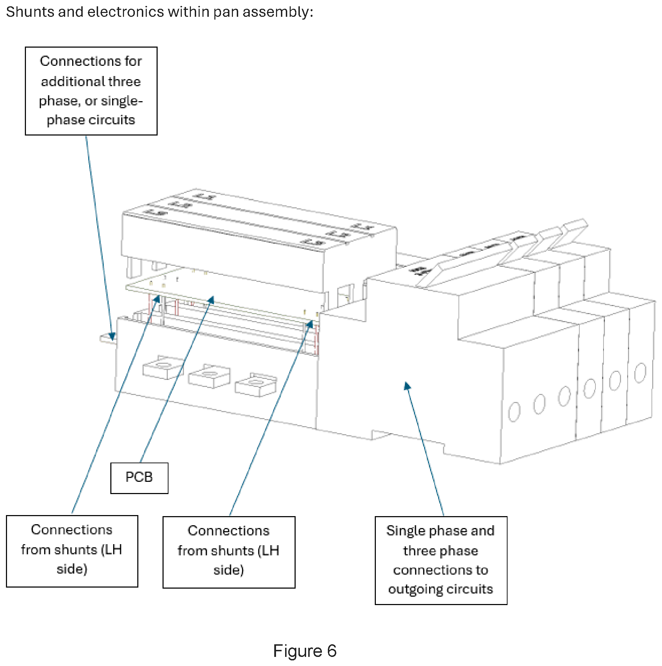

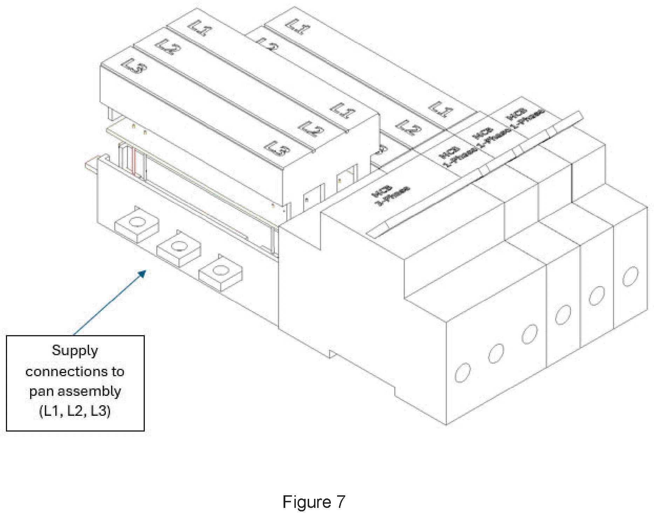

Figures 6 and 7 illustrate further perspectives of the pan assembly to show the shunts and electronics within the pan assembly. The pan assembly is provided with a printed circuit board (PCB) positioned within the structure. The PCB comprises respective pins coupled to a pair of connections on either side of each shunt resistor, to which wiring for current measurement circuitry and/or power or energy metering can be connected. These connections enable electrical measurements to be taken from the integrated shunt resistors within the current carriers. For example, a measured voltage drop across each integrated shunt resistor may be acquired and transmitted to the PCB for processing or for transmission to external measurement equipment.

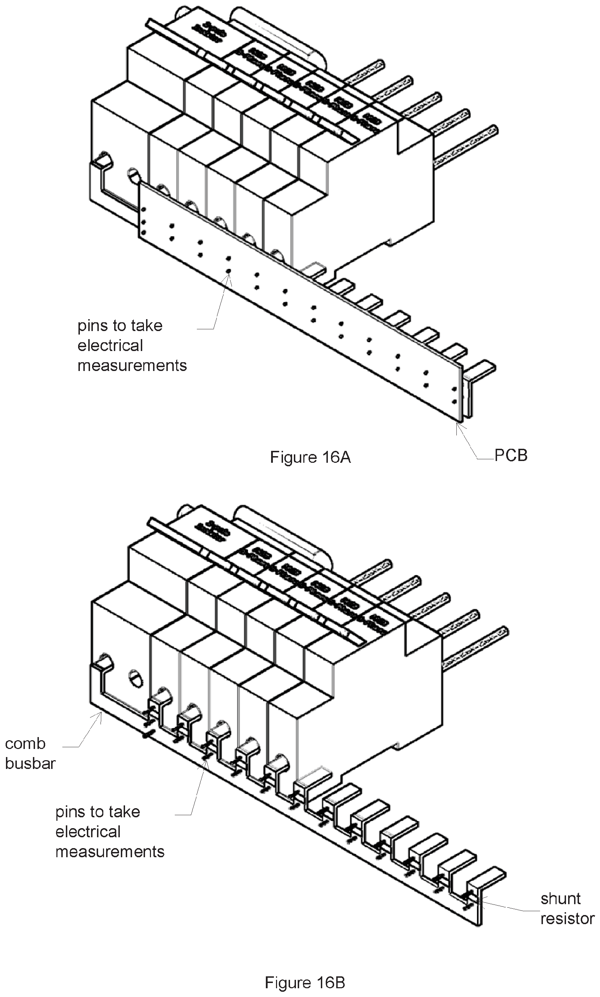

Another example of a PCB for a comb busbar arrangement is shown in Figure 16A. The PCB is provided adjacent to the protrusions from the comb busbar. As shown in the same example with the PCB removed in Figure 16B, the pins are provided on either side of the shunt resistors integrated into each protrusion to allow electrical measurements to be taken from across the shunt resistors. The current may then be determined by dividing the voltage drop by a known resistance of the integrated shunt resistors. The power consumed by the subsidiary circuit may then be determined by multiplying the current by the supply voltage (e.g. 240 volts minus the voltage drop of the shunt resistor). The proposed approach therefore allows for individual monitoring of the power draw by each subsidiary circuit.

As shown, the current measurement shunts and associated electronics may be integrated into the distribution circuitry within the pan assembly without requiring additional space for current transformers or other external monitoring devices. The pan assembly may be provided in a housing that encloses the busbar arrangement while providing organized connection points for both the incoming three-phase supply and the outgoing connections to circuit protection devices providing the electrical connections to subsidiary circuits.

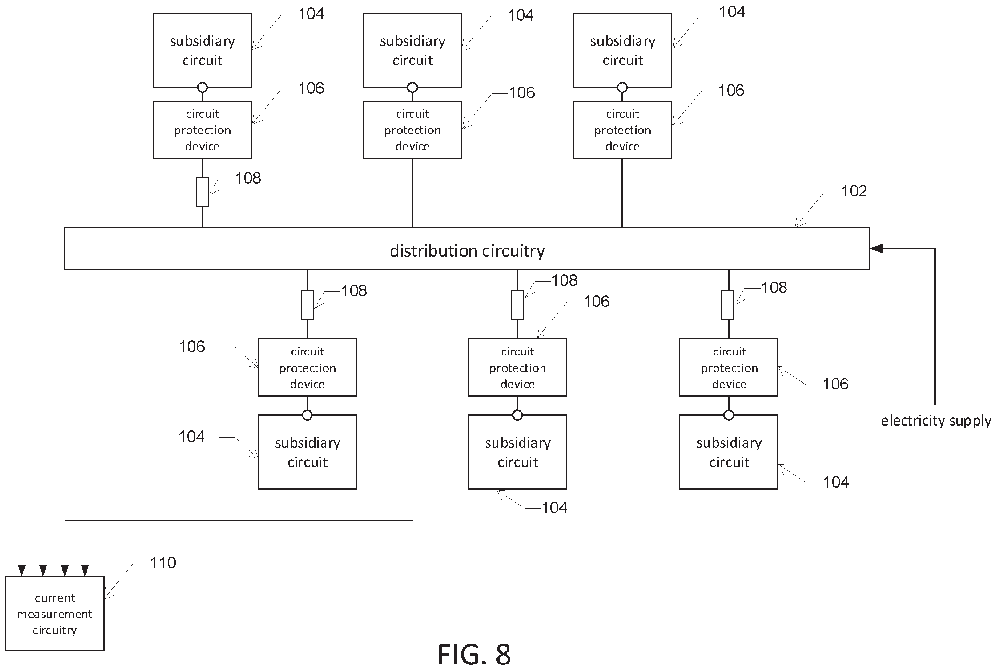

Figure 8 illustrates an electrical distribution system (e.g. distribution board, such as consumer unit), comprising distribution circuitry 102 including current carriers to respective subsidiary circuits 104, where at least two of the current carriers comprise integrated shunt resistors 108 to enable electrical measurements (e.g. voltage drop across the shunt resistor 108) to be taken from a pair of output connections across each resistor. As shown in Figure 8, it is not essential for all subsidiary circuits 104 to have the integrated resistor 108 enabling integrated measurement, but in some examples each subsidiary circuit has the integrated measurement capability by having an integrated shunt resistor 108 on its corresponding current carrier.

The distribution circuitry 102 serves as a central component that receives the incoming electrical supply and distributes the electrical supply to multiple subsidiary circuits 104. This distribution circuitry 102 may be configured differently depending on the particular requirements of an installation. For example, a scalable installation for large commercial or industrial loads may configure the distribution circuitry 102 as a three-phase pan assembly, whereas a smaller installation for residential loads may configure the distribution circuitry 102 as a single-phase comb busbar. It will be appreciated that pan assemblies may also be configured to distribute a single-phase supply, and a comb busbar may be configured to distribute a three-phase supply. The subsidiary circuits 104 are provided with an electrical connection to the distribution circuitry 102 via current carriers. The configuration of the current carriers may vary depending on the configuration of the distribution circuitry 102, but any member which provides the electrical connection between the distribution circuitry 102 and a single subsidiary circuit 104 may be considered a current carrier in the proposed approach. In some examples, a current carrier may comprise a busbar made from a conductive material, e.g. copper. In other examples, current carriers may comprise a portion of a larger conducting member, such as a protrusion of a comb busbar.

In the illustrated example, the electrical distribution system includes six subsidiary circuits 104 in total. Each subsidiary circuit 104 is connected to the distribution circuitry 102 through a corresponding circuit protection device 106. The circuit protection devices 106 are positioned between the distribution circuitry 102 and the respective subsidiary circuits 104, providing protective functionality for each individual circuit branch leading to the subsidiary circuits 104. The integrated shunt resistors 108 are provided as part of (i.e. integrated in) the various current carriers, such that current drawn by a given subsidiary circuit 104 passes through an integrated shunt resistor 108.

For each integrated shunt resistor 108, a pair of output connections is provided to allow electrical measurements to be taken from across the integrated shunt resistor. These measurements are received by current measurement circuitry 110. Voltage drops from across the integrated shunt resistors 108 may be used for calculating the current and/or power drawn by each respective subsidiary circuit 104. The current measurement circuitry 110 may include, for example, a processing unit configured to calculate the current from the electrical measurements.

As shown in Figure 8, the point of measurement is on a distribution side of the circuit protection devices, allowing current measurement capability to be integrated into the electrical distribution system rather than requiring separate wiring on a subsidiary circuit side.

It will be appreciated that Figure 8 is a general example, and so various other aspects which are not illustrated for clarity may also be provided. For example, some subsidiary circuits 104 may not be provided with a circuit protection device 106 such that the current carrier provides a direct connection between the distribution circuitry 102 and the subsidiary circuit 104. There may also be more or fewer subsidiary circuits 104 provided as part of the electrical distribution system, any number of which may be provided with monitoring capability by providing a current carrier with an integrated shunt resistor 108 as described above.

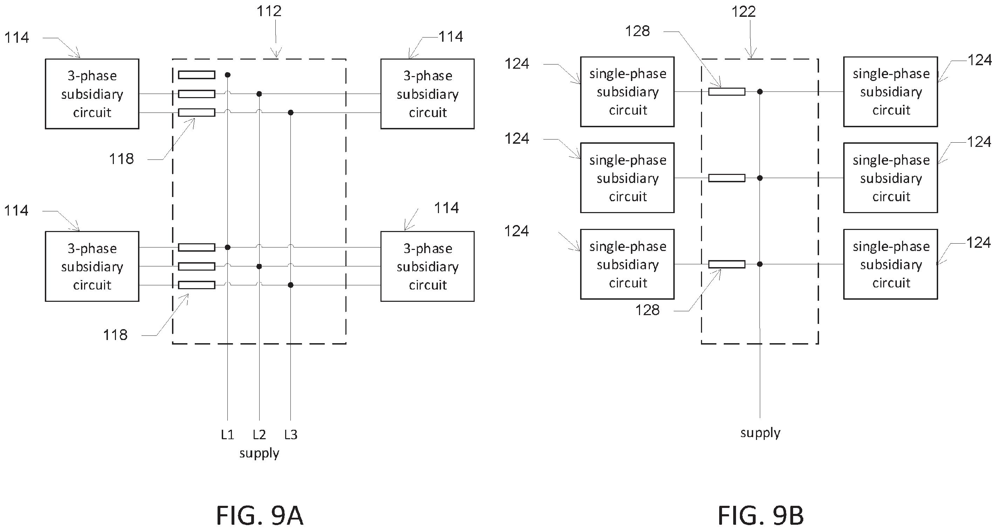

Figures 9A and 9B show alternative examples of shunt resistors integrated onto at least a subset of current carriers in three-phase (Figure 9A) and single-phase (Figure 9B) implementations.

In Figure 9A, distribution circuitry 112 receives a three-phase supply comprising lines L1, L2, and L3, shown at the bottom of the diagram. The system distributes the supply to four three-phase subsidiary circuits 114 arranged in two rows on either side of the distribution circuitry 112. Each three-phase subsidiary circuit 114 connects to the distribution circuitry through three current carriers corresponding to the three phase lines. The current carriers are represented by the horizontal lines extending from the central vertical bus conductors to each subsidiary circuit block. These current carriers may comprise copper busbars terminating at a connection point for connecting to the subsidiary circuits 114. The current carriers providing the electrical connection to the left-side subsidiary circuits 114 comprise integrated shunt resistors 118 as described in previous examples. By providing an integrated shunt resistor 118 in each of the three current carriers providing the connection to a subsidiary circuit 114, the currents drawn through each current carrier may be added together to obtain the total current drawn by the subsidiary circuit 114.

In Figure 9B, distribution circuitry 122 receives a single-phase supply, shown at the bottom of the diagram. The system distributes the supply to six single-phase subsidiary circuits 124. Each single-phase subsidiary circuit 124 connects to the distribution circuitry 122 through a single current carrier. As above, the current carrier may comprise a copper busbar terminating at a connection point for connecting to the subsidiary circuit 124. The current carriers providing the electrical connection to the left-side subsidiary circuits 124 comprise integrated shunt resistors 128 as described in previous examples. The configuration allows voltage drop measurements to be taken across each shunt resistor 128, enabling determination of current drawn by each corresponding subsidiary circuit 124.

In Figures 9A and 9B, the dashed lines surrounding the central distribution structure indicate the boundary of the pan assembly or distribution board enclosure. As shown, the integrated shunt resistors 118, 128 provide the current measurement functionality within the enclosure without requiring additional space.

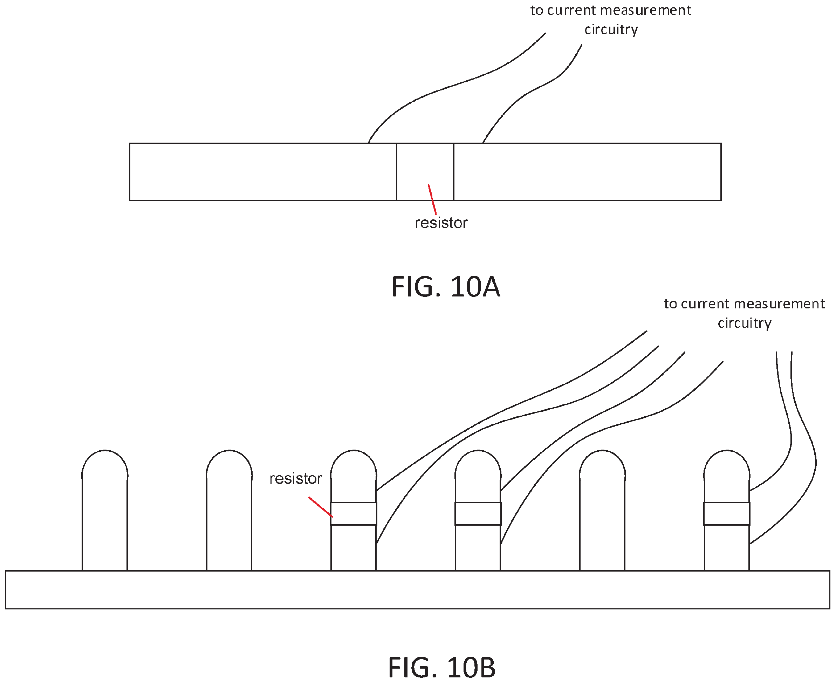

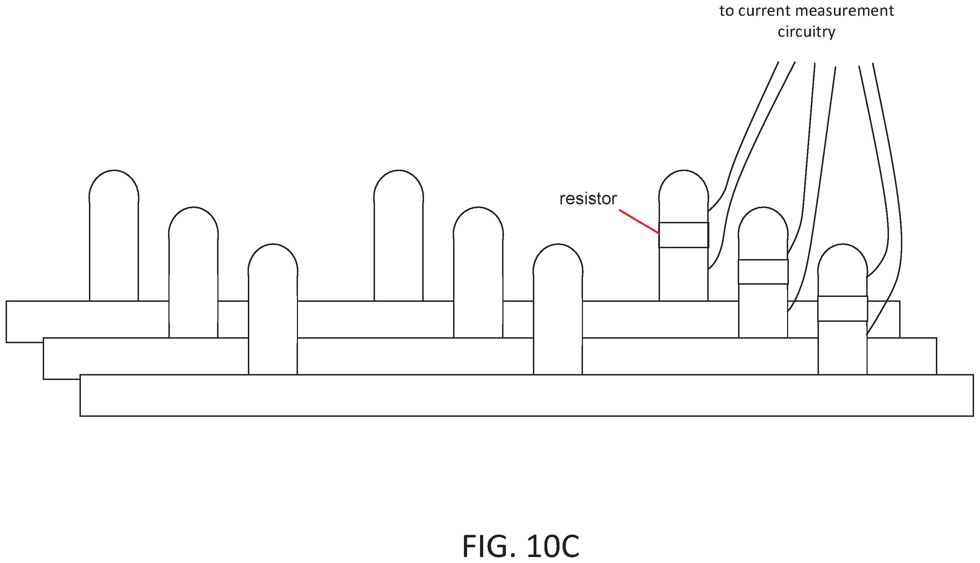

Figures 10A, 10B and 10C illustrate examples of current carriers with integrated shunt resistors for use in electrical distribution systems.

Figure 10A illustrates a current carrier (e.g. busbar, such as a busbar within a pan assembly for a three-phase distribution) which comprises an integrated shunt resistor and a pair of output connections for making electrical measurements across the shunt resistor. The busbar comprises an elongated body, with an integrated shunt resistor positioned along its length. The integrated shunt resistor is configured such that current passing through the electrical connection between distribution circuitry and a corresponding subsidiary circuit passes through the integrated shunt resistor. Wires may be connected to carry measurements from the pair of output connections on current carrier to current measurement circuitry. The integrated shunt resistor may forms a distinct section within the current carrier body. For example, a distinct section of resistive material, such as manganin, may be provided between two sections of conductive material, such as copper.

Figure 10B illustrates integrating shunt resistors into the protrusions of a comb busbar for a single-phase distribution board (the comb busbar being a component at which electrical current is distributed to multiple subsidiary circuits). A pair of output connections across each resistor enables current measurement of current drawn by the subsidiary circuit, by monitoring the voltage drop across the integrated shunt resistor. The comb busbar comprises a horizontal base bar with multiple protrusions extending from the base bar. Each protrusion may serve as an individual current carrier configured to provide an electrical connection between the base bar and a corresponding subsidiary circuit. At least some of the protrusions include integrated shunt resistors positioned within the protrusions. It will be appreciated that subsidiary circuits that are connected to the protrusions without an integrated shunt resistor will not be capable of being monitored by this proposed approach. Accordingly, subsidiary circuits that are more important to monitor (e.g. subsidiary circuits for powering commercial equipment) may be connected to the protrusions with integrated shunt resistors. Meanwhile, less important subsidiary circuits (e.g. lighting) may be connected to the protrusions without integrated shunt resistors. In some examples, an integrated shunt resistor may be provided on every protrusion of the comb busbar.

A pair of wires extends from each pair of output connections across the shunt resistors to current measurement circuitry to allow electrical measurements to be taken from across each integrated shunt resistor. The arrangement enables voltage drop measurements across each integrated shunt resistor, from which the current drawn by each connected subsidiary circuit may be calculated.

Figure 10C illustrates integrating shunt resistors into protrusions of comb busbars for a three-phase distribution board. In contrast to the single-phase comb busbar of Figure 10C, three base bars may each be supplied with a different phase of a three-phase supply. A subsidiary circuit may then be connected to a group of three protrusions, with one from each comb busbar, so as to receive current from all three phases. As shown, each current carrier in one group have been provided with integrated shunt resistors and a pair of output connections to allow electrical measurements to be taken from across each integrated shunt resistor. Since a subsidiary circuit in this example will draw current from all three protrusions, the total current drawn by that subsidiary circuit may be calculated by adding the currents measured for each protrusion.

As in previous examples, some current carriers may omit an integrated shunt resistor if, for example, it is not necessary or important to measure the current drawn by the corresponding subsidiary circuit. Some examples may provide the integrated shunt resistor in every protrusion of all three comb busbars.

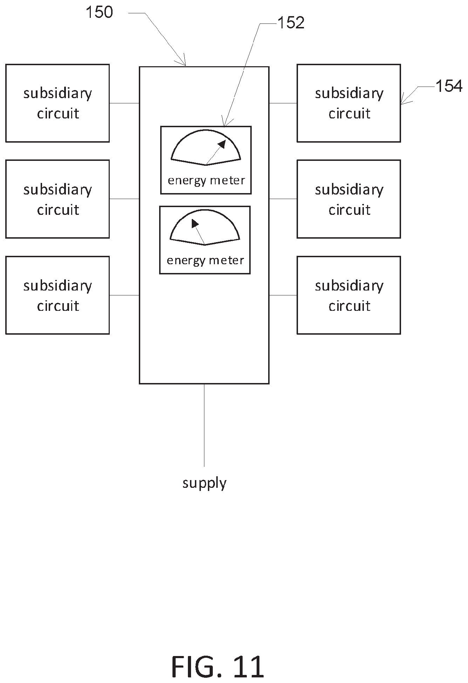

Figure 11 illustrates an example of a distribution board 150 comprising integrated energy meters 152, which use the voltage drops across each shunt resistor to calculate power and energy consumed by corresponding subsidiary circuits 154. In other examples, the voltage measurements from each shunt resistor could output to an external calculation unit, external to the distribution assembly, so integrated energy metering is not essential. The distribution board 150 may be an enclosure or housing covering a pan assembly or comb busbar assembly as described previously. The input supply is provided and distributed by distribution circuitry within the distribution board 150. The distribution board 150 incorporates two energy meters 152 positioned as part of the housing and each depicted with a dial indicator to display an indication of energy usage by each of the subsidiary circuits 154. The indication may be computed based on current measurements taken over time using measured voltage drops across integrated shunt resistors as described previously. In various examples, the energy meters 152 may indicate a value in kilowatt-hours (kWh) representative of the amount of energy consumed by one of the subsidiary circuits 154, or may indicate a current power draw in kilowatts (kW). It will be appreciated that any relevant metric which may be calculated using at least the voltage drop from the integrated shunt resistors may be indicated by the energy meters 152.

It will be appreciated that the energy meters 152 themselves may take many forms. While an analogue dial indicator is shown in Figure 11, the energy meters could also comprise a digital or graphical readout of energy use by a subsidiary circuit 154. In each example, the provision of the indicator as part of the housing removes any need to open the housing to take electrical measurements, thereby improving convenience and safety.

In alternative implementations, the voltage measurements from each shunt resistor can be output to an external calculation unit located external to the distribution assembly. In such implementations, the external calculation unit receives the voltage drop measurements from the pairs of output connections across the shunt resistors and performs the power and energy calculations. Integrated energy metering within the distribution board 120 is therefore not a requirement of the proposed distribution system, as the calculation functionality can be performed externally to the distribution system.

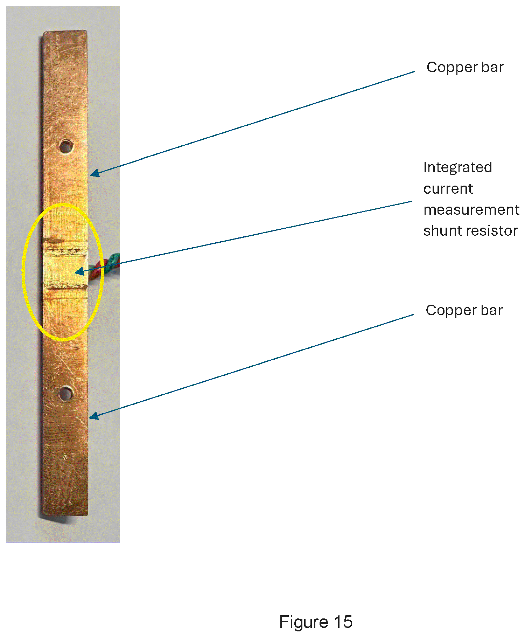

Figure 15 illustrates an example of a copper busbar manufactured with the integrated current measurement shunt resistor. The process to manufacture the current carrier including the integrated shunt resistor can involve cutting the copper bar and spot-welding a small piece in series. For the single phase examples where the resistor is in the protrusions on the comb busbar assembly, this resistor can be welded to be in series with the small copper tang that the MCB, RCBO etc. connects to.

The piece used as the integrated shunt resistor may be made of a resistive material, such as manganin. As shown, two wires are connected to each side of the shunt resistor to enable voltage drop measurements to be taken from across the shunt resistor, allowing calculation of the current being drawn by a connected circuit.

Advantages of the present technique include:
- the point of measurement is on the distribution side, not the subsidiary side, so that it can be integrated into the distribution board, rather than requiring separate wiring on the copper tang connections to each subsidiary circuit.
- the integrated nature of the measurement capability into the distribution board design greatly reduces installation time for the installer;
- hence, the technique provides both space savings (useful when the board needs to be installed in confined spaces), and time saving for the installer by reducing the amount of manual wiring needed to implement the current measurement;
- space/time savings are particularly significant when multiple (e.g. all) subsidiary circuits coupled to the distribution board require current measurements.

Some examples are set out in the following clauses:
1. An electrical distribution system comprising:
   distribution circuitry configured to distribute an electrical supply to a plurality of subsidiary circuits;
   a plurality of current carriers, each current carrier configured to provide an electrical connection between the distribution circuitry and a corresponding subsidiary circuit,
   wherein at least two of the plurality of current carriers each comprise:
      an integrated shunt resistor configured such that current passing through the electrical connection between the distribution circuitry and the corresponding subsidiary circuit passes through the integrated shunt resistor; and
      a pair of output connections configured to allow electrical measurements to be taken from across the integrated shunt resistor.
2. The electrical distribution system of clause 1, in which the distribution circuitry is arranged in a pan assembly.
3. The electrical distribution system of clause 1, in which the distribution circuitry is arranged as a comb linking bar, and each current carrier comprises a respective protrusion of the comb linking bar.
4. The electrical distribution system of any preceding clause, in which the electrical distribution system comprises an electrical distribution board.
5. The electrical distribution system of clause 4, in which the electrical distribution board comprises a consumer unit.
6. The electrical distribution system of any of clauses 4 and 5, in which the pair of output connections is configured to allow electrical measurements to be taken from a point on the current carrier that is integrated inside the electrical distribution board.
7. The electrical distribution system of any preceding clause, in which each of the subsidiary circuits corresponds to at least one current carrier comprising the integrated shunt resistor and the pair of output connections.
8. The electrical distribution system of any preceding clause, comprising current measurement circuitry configured to take the electrical measurements from the pair of output connections and to determine a magnitude of current that is drawn by the corresponding subsidiary circuit.
9. The electrical distribution system of clause 8, wherein the current measurement circuitry is configured to determine the magnitude of current for each of the at least two of the plurality of current carriers.
10. The electrical distribution system of any of clauses 8 and 9, wherein the current measurement circuitry is configured to determine the magnitude of current for any of the subsidiary circuits.
11. The electrical distribution system of any of clauses 8 to 10, wherein the current measurement circuitry is permanently connected to the pair of output connections.
12. The electrical distribution system of any of clauses 8 to 10, wherein the current measurement circuitry is removably connected to the pair of output connections.
13. The electrical distribution system of any preceding clause, wherein
   each current carrier is configured to provide an electrical connection between the distribution circuitry and a circuit protection device for the corresponding subsidiary circuit.
14. The electrical distribution system according to clause 13, in which the pair of output connections is at a portion of the current carrier that is on a distribution side of the circuit protection device, the distribution side of the circuit protection device being a side connected to the distribution circuitry and the distribution side being opposite to a subsidiary circuit side at which the circuit protection device is connected to the corresponding subsidiary circuit.
15. The electrical distribution system of any of clauses 13 and 14, wherein the circuit protection device comprises a circuit breaker or a fuse.
16. The electrical distribution system of any preceding clause, wherein the electrical measurements comprise a voltage drop across the integrated shunt resistor.
17. The electrical distribution system of any of clauses 1 to 15, wherein the electrical measurements comprise a current measurement based on a voltage drop across the integrated shunt resistor and a resistance of the integrated shunt resistor.
18. The electrical distribution system of any preceding clause, wherein the at least two current carriers provide electrical connections between the distribution circuitry and at least two different subsidiary circuits.
19. The electrical distribution system of any preceding clause, wherein
   the electrical supply comprises a three-phase supply; and
   three of the plurality of current carriers are configured to provide three out-of-phase electrical connections between the distribution circuitry and a given one of the subsidiary circuits.
20. The electrical distribution system of clause 19, wherein
   each of the three of the plurality of current carriers comprise the integrated shunt resistor and the pair of output connections.
21. The electrical distribution system of any of clauses 1 to 18, wherein
   the electrical supply comprises a single phase-supply;
   each of the plurality of current carriers are configured to provide the electrical connection to different subsidiary circuits.
22. The electrical distribution system of any preceding clause, wherein each of the plurality of current carriers comprises a busbar.
23. The electrical distribution system of any of clauses 1 to 21, wherein each of the plurality of current carriers comprises a protrusion of a comb linking bar.
24. The electrical distribution system of clause 23, wherein the protrusion of the comb linking bar is to facilitate connection of a circuit protection device that subsequently supplies a subsidiary load.
25. The electrical distribution system of any preceding clause, wherein the integrated shunt resistor is made of resistive material.
26. The electrical distribution system of clause 25, wherein the resistive material is manganin.
27. The electrical distribution system of any preceding clause, wherein at least one of the plurality of current carriers is configured to provide an electrical connection between the distribution circuitry and a corresponding subsidiary circuit without passing current through an integrated shunt resistor.
28. The electrical distribution system of any preceding clause comprising:
   current measurement circuitry configured to take the electrical measurements from the pair of output connections and to determine a magnitude of current that is drawn by the corresponding subsidiary circuit; and
   at least one metering module connected to the current measurement circuitry and configured to display an indication of energy usage by each of the subsidiary circuits.
29. The electrical distribution system of clause 28, wherein the distribution circuitry is arranged in a pan assembly and the at least one metering module is positioned in a housing configured to cover the pan assembly.

In a brief overall summary, an electrical distribution system comprises distribution circuitry to distribute an electrical supply to a plurality of subsidiary circuits, and a plurality of current carriers, each current carrier providing an electrical connection between the distribution circuitry and a corresponding subsidiary circuit. At least two of the plurality of current carriers each comprise an integrated shunt resistor configured such that current passing through the electrical connection between the distribution circuitry and the corresponding subsidiary circuit passes through the integrated shunt resistor, and a pair of output connections configured to allow electrical measurements to be taken from across the integrated shunt resistor.

In the present application, lists of features preceded with the phrase "at least one of" mean that any one or more of those features can be provided either individually or in combination. For example, "at least one of: A, B and C" encompasses any of the following options: A alone (without B or C), B alone (without A or C), C alone (without A or B), A and B in combination (without C), A and C in combination (without B), B and C in combination (without A), or A, B and C in combination.

Although illustrative embodiments of the invention have been described in detail herein with reference to the accompanying drawings, it is to be understood that the invention is not limited to those precise embodiments, and that various changes and modifications can be effected therein by one skilled in the art without departing from the scope of the invention as defined by the appended claims.

## Claims

1. An electrical distribution system comprising:
distribution circuitry configured to distribute an electrical supply to a plurality of subsidiary circuits, wherein the distribution circuitry comprises a comb linking bar;
a plurality of current carriers, each current carrier comprising a respective protrusion of the comb linking bar, and configured to provide an electrical connection between the distribution circuitry and a corresponding subsidiary circuit,
wherein at least two of the plurality of current carriers each comprise:
an integrated shunt resistor configured such that current passing through the electrical connection between the distribution circuitry and the corresponding subsidiary circuit passes through the integrated shunt resistor; and
a pair of output connections configured to allow electrical measurements to be taken from across the integrated shunt resistor.

2. The electrical distribution system according to claim 1, in which the electrical distribution system comprises an electrical distribution board.

3. The electrical distribution system according to claim 2, in which the electrical distribution board comprises a consumer unit.

4. The electrical distribution system according to any of claims 2 and 3, in which the pair of output connections is configured to allow electrical measurements to be taken from a point on the current carrier that is integrated inside the electrical distribution board.

5. The electrical distribution system according to any preceding claim, in which each of the subsidiary circuits corresponds to at least one current carrier comprising the integrated shunt resistor and the pair of output connections.

6. The electrical distribution system of any preceding claim, comprising current measurement circuitry configured to take the electrical measurements from the pair of output connections and to determine a magnitude of current that is drawn by the corresponding subsidiary circuit.

7. The electrical distribution system of claim 6, wherein the current measurement circuitry is configured to determine the magnitude of current for each of the at least two of the plurality of current carriers.

8. The electrical distribution system of any preceding claim, wherein
each current carrier is configured to provide an electrical connection between the distribution circuitry and a circuit protection device for the corresponding subsidiary circuit.

9. The electrical distribution system according to claim 8, in which the pair of output connections is at a portion of the current carrier that is on a distribution side of the circuit protection device, the distribution side of the circuit protection device being a side connected to the distribution circuitry and the distribution side being opposite to a subsidiary circuit side at which the circuit protection device is connected to the corresponding subsidiary circuit.

10. The electrical distribution system of any preceding claim, wherein the electrical measurements comprise either:
a voltage drop across the integrated shunt resistor; or
a current measurement based on a voltage drop across the integrated shunt resistor and a resistance of the integrated shunt resistor.

11. The electrical distribution system of any preceding claim, wherein
the electrical supply comprises a three-phase supply; and
three of the plurality of current carriers are configured to provide three out-of-phase electrical connections between the distribution circuitry and a given one of the subsidiary circuits.

12. The electrical distribution system of claim 11, wherein
each of the three of the plurality of current carriers comprise the integrated shunt resistor and the pair of output connections.

13. The electrical distribution system of any of claims 1 to 10, wherein
the electrical supply comprises a single phase-supply;
each of the plurality of current carriers are configured to provide the electrical connection to different subsidiary circuits.

14. The electrical distribution system of any preceding claim, wherein the protrusion of the comb linking bar is to facilitate connection of a circuit protection device that subsequently supplies a subsidiary load.

15. The electrical distribution system of any preceding claim comprising:
current measurement circuitry configured to take the electrical measurements from the pair of output connections and to determine a magnitude of current that is drawn by the corresponding subsidiary circuit; and
at least one metering module connected to the current measurement circuitry and configured to display an indication of energy usage by each of the subsidiary circuits.
